# FASCICULE DE BREVET EUROPEEN

(11) **EP 3 205 743 B1**
(45) Date de publication et mention de la délivrance du brevet: **02.06.2021**
(21) Numéro de dépôt: 17155206.0
(22) Date de dépôt: 08.02.2017
(51) Int. Cl.: C23C 16/56, C23C 16/30, G01N 29/02, C23C 16/40, H01L 21/02, G01N 30/02, B01J 20/10, B01J 20/283, B01J 20/32, G01N 29/24

(54) **PROCÉDÉ SIMPLIFIÉ DE RÉALISATION D'UNE COUCHE MINCE DE SIOCH POREUX**
VERFAHREN ZUR HERSTELLUNG EINER DÜNNEN PORÖSEN SIOCH SCHICHT
SIMPLIFIED PROCESS TO PRODUCE A THIN LAYER OF POROUS SIOCH

(30) Priorité: 09.02.2016 FR 1651002
(43) Date de publication de la demande: 16.08.2017
(73) Titulaire: COMMISSARIAT À L'ÉNERGIE ATOMIQUE ET AUX ÉNERGIES ALTERNATIVES, 75015 Paris (FR)
(72) Inventeur: RICOUL, Florence, 38950 QUAIX-EN-CHARTREUSE (FR); EL SABAHY, Julien, 38000 GRENOBLE (FR); JOUSSEAUME, Vincent, 38700 LE SAPPEY EN CHARTREUSE (FR)
(74) Mandataire: Brevalex

(56) Documents cités:
- WO-A1-2014/068004
- WO-A1-2015/097282
- FR-A1- 2 918 997
- US-A1- 2006 079 099
- US-A1- 2007 161 256
- US-A1- 2010 003 835
- US-A1- 2013 043 514

## Description

### DOMAINE TECHNIQUE ET ÉTAT DE LA TECHNIQUE ANTÉRIEURE

La présente invention se rapporte à un procédé simplifié de réalisation d'une couche de SiOCH poreux plus particulièrement, d'une couche mince de SiOCH poreux.

Le SiOCH poreux est utilisé en microélectronique pour réaliser des interconnexions présentant des propriétés diélectriques.

Il est également utilisé dans des capteurs de gaz gravimétriques, tels que décrits dans le document WO201597282. Il permet de réaliser des capteurs de gaz gravimétriques à limite de détection abaissée. Il peut également être utilisé pour former une couche stationnaire dans une colonne de chromatographie en phase gazeuse telle que décrite dans le document WO2014 068004.

La couche de SiOCH peut être déposée par enduction ou spin coating en terminologie anglo-saxonne, par dépôt chimique en phase vapeur ou CVD pour chemical vapor deposition en terminologie anglo-saxonne, et plus particulièrement par dépôt chimique en phase vapeur assisté par plasma ou PECVD pour Plasma-enhanced chemical vapor deposition.

Le dépôt par PECVD de SiOCH poreux met en œuvre deux précurseurs dont l'un est un agent porogène qui est ensuite éliminé. Le procédé de dépôt comporte les étapes : dépôt d'un film mince en introduisant dans l'enceinte de l'installation de PECVD deux précurseurs dont l'un est un agent porogène à une température de l'ordre de 300°C et traitement thermique assisté par un rayonnement ultraviolet à une température d'environ 400°C. Ce traitement thermique a pour effet de supprimer le porogène tout en conservant de bonnes propriétés mécaniques à la couche mince. La couche mince comporte alors des pores.

Le document O. Gourhant, G. Gerbaud, A. Zenasni, L. Favennec, P. Gonon, and V. Jousseaume, 'Crosslinking of porous SiOCH films involving Si-O-C bonds: Impact of deposition and curing', J. Appl. Phys., 108 (2010) 124105 décrit un exemple de réalisation de films minces de SiOCH poreux par PECVD mettant en œuvre comme précurseurs, un précurseur organosilicié, tel que le DEMS (DiEthoxyMethylSilane) et un précurseur porogène tel que le norbornadiène. La température de dépôt est entre 200°C et 300°C. Un traitement thermique assisté par un rayonnement UV à 400°C a lieu.

Ce procédé donne satisfaction cependant il met en œuvre plusieurs précurseurs.

Le document US7906174 décrit un procédé de dépôt d'oxyde de carbone dopé par PECVD utilisant un précurseur qui possède des triples-liaisons. La température du dépôt par PECVD est comprise entre 300°C et 350°C. Un traitement thermique assisté par un rayonnement UV a ensuite lieu. Ce procédé requiert un budget thermique relativement important. Le traitement thermique assisté par un rayonnement UV a pour objectif d'améliorer la tenue mécanique des dépôts et d'abaisser sa constante diélectrique.

Il existe également un autre procédé pour réaliser un dépôt de film mince de SiOCH poreux décrit dans le document FR2918997. Ce procédé comporte par exemple le dépôt d'une couche mince par PECVD, le dépôt d'une couche d'oxyde de silicium sur la couche mince, l'application d'un traitement thermique à 400°C assisté par un rayonnement UV qui permet le moussage de la couche mince et l'apparition d'une porosité dans la couche mince. Ce procédé donne satisfaction mais est relativement complexe.

Le document US2007/161256 décrit un procédé de réalisation d'une couche de SiOCH poreux mettant en œuvre un précurseur avec un porogène organique intégré.

Les documents US2006/079099 et US2013/043514 décrivent des méthodes de réalisation d'une couche mince de SiOCH poreux mettant en œuvre un précurseur intégrant un porogène.

On cherche à simplifier les procédés de réalisation de couche de SiOCH poreux et à réduire leur consommation énergétique.

### EXPOSÉ DE L'INVENTION

Le but de la présente invention est par conséquent de réaliser un procédé de dépôt de SiOCH poreux simplifié par rapport aux procédés de l'état de la technique et ayant une consommation énergétique réduite par rapport aux procédés de l'état de la technique.

C'est un but supplémentaire de l'invention d'offrir un procédé permettant la formation d'une couche mince de SiOCH poreux ayant une porosité d'au moins 4%.

Le but énoncé ci-dessus est atteint par un procédé comportant les étapes :
- dépôt de la couche de SiOCH par dépôt chimique en phase vapeur à partir d'un seul précurseur à une température comprise entre 100°C et 250°C,
- recuit, avantageusement assisté par rayonnement UV.

Les inventeurs ont découvert de manière surprenante qu'en réalisant un dépôt d'une couche de SIOCH par CVD à partir d'un seul précurseur à relativement basse température, i.e. inférieure ou égale à 250°C, et ensuite en réalisant un traitement thermique, de préférence assisté par rayonnement ultraviolet, la couche de SiOCH présentait une porosité au moins égale à celle d'une couche formée en mettant en œuvre au moins deux précurseurs dont l'un est un agent porogène. Le procédé de réalisation est donc simplifié car il ne met en œuvre qu'un seul précurseur. En outre la température de dépôt par CVD étant réduite par rapport à celles des procédés de l'état de la technique, ce procédé a donc un budget thermique réduit.

De préférence, la température de dépôt de SiOCH est de l'ordre de 150°C.

De préférence, le dépôt se fait par PECVD.

La présente invention a alors pour objet un procédé de réalisation d'une couche mince de SiOCH poreux comportant les étapes :
- dépôt d'une couche mince de SiOCH par dépôt chimique en phase vapeur à partir d'un seul précurseur choisi parmi le diméthylsilane, le triméthysilane et le tétraméthylsilane, à une température comprise entre 100°C et 250°C,
- traitement thermique de ladite couche mince à une température comprise entre 350°C et 500°C.

Le dépôt est avantageusement réalisé par dépôt chimique en phase vapeur assisté par plasma.

De manière préférée, le traitement thermique est assisté par un rayonnement UV.

Le précurseur appartient à la famille des méthyl silane.

De préférence, le traitement thermique est réalisé à 400°C.

La température de dépôt est avantageusement égale à 150°C.

La couche mince obtenue a par exemple un taux de porosité d'au moins 4%.

La présente invention a également un procédé de réalisation d'une colonne de chromatographie comportant au moins une étape de réalisation d'une couche de SiOCH poreux sur une surface intérieure de la colonne, ladite étape mettant en œuvre le procédé de dépôt selon l'invention.

La présente invention a également un procédé de réalisation d'un capteur de gaz comportant une couche de SiOCH poreux destiné à adsorber au moins une espèce d'intérêt, ledit procédé comportant une étape de réalisation de ladite couche mettant en œuvre le procédé de dépôt selon l'invention.

### BRÈVE DESCRIPTION DES DESSINS

La présente invention sera mieux comprise sur la base de la description qui va suivre et des dessins en annexe sur lesquels:
- les figures 1A et 1B sont des représentations schématiques d'étapes d'un procédé de réalisation d'une couche mince de SiOCH poreux selon l'invention,
- la figure 2 est une représentation graphique du taux de porosité ouverte en % en fonction de la température de dépôt de la couche de SiOCH,
- la figure 3 est une représentation graphique de la variation du taux de porosité ouverte en % en fonction de la durée en minutes du recuit,
- la figure 4 est une représentation graphique de la variation du taux de mérite K de deux couches de SiOCH l'une avec recuit assisté par un rayonnement UV et l'autre sans recuit, en fonction de la concentration en toluène.

### EXPOSÉ DÉTAILLÉ DE MODES DE RÉALISATION PARTICULIERS

Le procédé de réalisation d'une couche mince de SiOCH poreux selon l'invention.

Le terme SiOCH désigne un composé de formule SiOxCyHz avec :
- x compris entre 1 et 2, de préférence entre 1,4 et 1,8,
- y compris entre 0,7 et 3, de préférence entre 0,8 et 2,5,
- z compris entre 2,5 et 5, de préférence entre 3 et 4,5.

Dans la présente demande, on entend par « couche mince », une couche d'épaisseur comprise entre 10 nm et 2µm, de préférence entre 20 nm et 500 nm.

Le procédé comporte l'étape de dépôt d'une couche mince de SiOCH 2 sur un substrat 4 ou support qui peut être par exemple une partie d'un dispositif micro et/ou nanoélectronique en vue de réalisation des portions électriquement isolantes, ou une zone d'un capteur ou la surface intérieure d'une colonne de chromatographie en phase gazeuse.

Le dépôt de la couche mince est réalisé par un procédé de dépôt chimique en phase vapeur ou CVD pour Chemical Vapor Deposition en terminologie anglo-saxonne, et avantageusement par dépôt chimique en phase vapeur assisté par plasma ou PECVD pour Plasma Enhanced Chemical Vapor Deposition.

Le dépôt de la couche mince est réalisé dans un équipement de CVD ou PECVD de l'état de la technique qui comporte une enceinte 6 étanche munie de moyens de chauffage 8 de l'élément 4 sur lequel on souhaite faire le dépôt et de moyens pour introduire des substances dans l'enceinte.

Dans le procédé selon l'invention, un seul précurseur P est introduit dans l'enceinte.

A titre d'exemple, le précurseur est du triméthyl silane de formule C₃H₁₀Si également désigné 3MS. Un flux d'oxygène est également injecté dans l'enceinte.

Les types de précurseurs de type méthyl silane utilisés sont le diméthylsilane ou le tétraméthylsilane associé à un flux d'oxygène.

Le substrat 4 ou le support sur lequel on souhaite réaliser la couche mince 2 est chauffé à une température comprise entre environ 100°C et 250°C.

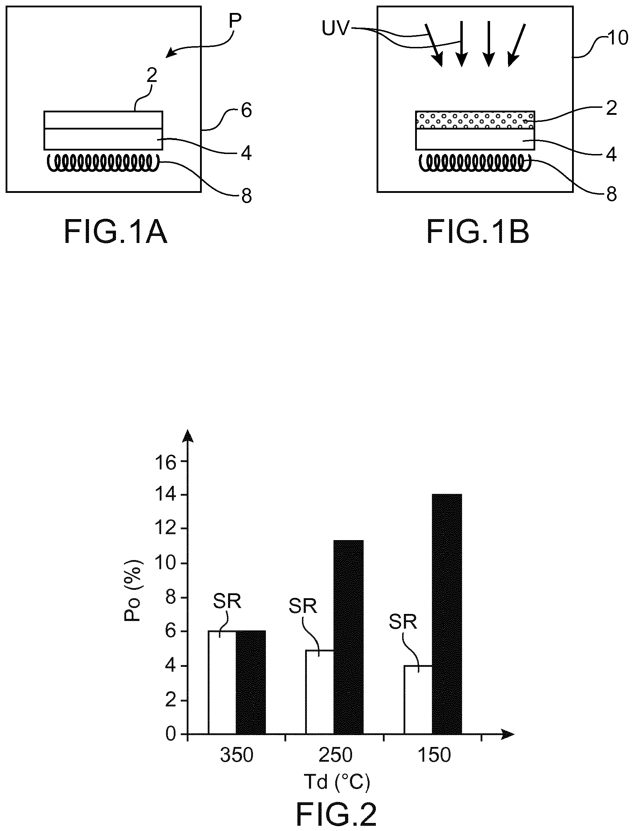

L'élément ainsi obtenu est représenté sur la figure 1A.

Lors d'une étape suivante une étape de recuit du substrat 4 comportant la couche mince 2 a lieu. L'élément est disposé par exemple dans une autre chambre 10 de l'équipement. La température de recuit est par exemple comprise entre 350°C et 500°C. Le recuit a par exemple lieu à 400°C pendant quelques minutes. De préférence le recuit est assisté par un rayonnement ultraviolet symbolisé par les flèches désignées UV, ce traitement permet de réduire la durée requise pour le recuit.

L'élément ainsi obtenu est représenté sur la figure 1B.

Il résulte de ce procédé que la couche mince 2 de SIOCH présente un taux de porosité ouverte élevé et au moins égal à celui qui peut être obtenu par des procédés de l'état de la technique notamment ceux mettant en œuvre un porogène.

Sur la figure 2, on peut voir des mesures de taux de porosité Po en % d'une couche mince de SiOCH poreux réalisée selon le procédé de l'invention pour différentes températures de dépôt Td et une mesure de taux de porosité d'une couche déposée à 350°C, et les taux de porosité de couches de SiOCH déposées aux mêmes températures mais sans recuit assisté par un rayonnement UV désignés par SR.

Les conditions de dépôt sont les suivantes :
Les couches minces ont été déposées par PECVD dans un équipement Applied Materials Centura 5200, en utilisant le 3MS comme précurseur, avec un flux de 700 cm³/min, un flux de O₂ de 100 cm³/min, une pression dans l'enceinte d'environ 5,3 mbar et un plasma dont la puissance est de 700 W.

Les recuits ont eu lieu à 400°C pendant 7 minutes avec un équipement Producer SE de la société Applied Materials.

La porosité ouverte a été caractérisée par ellipso-porosimétrie avec un équipement EP12 de la société SOPRA, la molécule sonde étant du toluène.

Selon le procédé de l'invention, la couche mince de SiOCH déposée à 250°C a une porosité ouverte de 11% environ et la couche mince de SiOCH déposée à 150°C a une porosité ouverte de 14%.

En revanche un dépôt d'une couche mince à 350°C ne présente qu'un taux de porosité ouverte de 4%.

En outre on constate que les couches minces déposées à 250° et 150°C mais n'ayant pas subies de traitement thermique ont respectivement des porosités de l'ordre de 5% et 4% respectivement.

Dans le cas de la couche mince déposée à 350°C elle présente le même taux de porosité de 4% qu'elle est subie ou non un traitement thermique.

On constate donc que le procédé selon l'invention combinant un dépôt d'un film mince à une température inférieure ou égale à 250°C et un traitement thermique, avantageusement assisté par un rayonnement UV, permet d'atteindre des taux de porosité élevés.

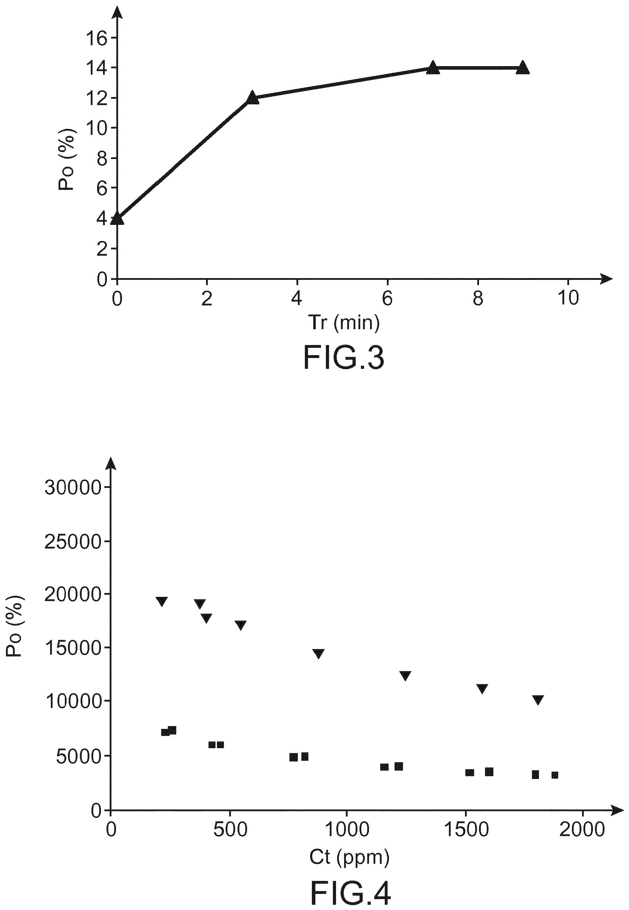

L'effet de la combinaison du dépôt à température inférieure ou égale à 250°C et de traitement thermique est illustré par la figure 3 qui montre la variation du taux de porosité ouverte d'un couche de SiOCH déposée à 150°C part PECVD utilisant comme précurseur le 3MS, en fonction de la durée d'un recuit tr en minutes assisté par un rayonnement UV. La couche a une épaisseur de 400 nm.

On constate l'augmentation du taux de porosité en fonction de la durée du recuit avec un plateau à 14% à partir d'environ 7 min.

Sur la figure 4, on peut voir représentée graphiquement la variation du facteur de mérite K en fonction de la concentration en toluène et en ppm pour deux couches de SiOCH déposée à 150°C, l'une ayant subi un traitement thermique assisté par un rayonnement UV (points en forme de triangle) et l'autre n'ayant pas subi de traitement thermique (points en forme de carré). Les couches de SiOCH ont une épaisseur de 400 nm. Le facteur de mérite K est le rapport entre la concentration de l'espèce d'intérêt adsorbée sur la concentration de l'espèce d'intérêt dans le milieu environnant. Dans le cas présent le toluène est l'espèce d'intérêt.

On constate que le facteur de mérite K est sensiblement plus élevée dans le cas de la couche de SIOCH réalisée selon l'invention que celui de la couche de SiOCH sans recuit. On constate un gain d'environ 2,6.

Grâce au procédé selon l'invention, on peut donc obtenir un dépôt de couche mince de SiOCH poreux ayant des propriétés au moins équivalentes à celles obtenue par d'autres procédés plus complexes et/ou nécessitant des températures plus élevées. Les propriétés en question sont par exemple le taux de porosité et le facteur de mérite.

Les couches de SiOCH réalisées selon le procédé de l'invention sont donc particulièrement intéressantes pour réaliser par exemple des capteurs de gaz, pour réaliser des colonnes de chromatographie en phase gazeuse, en particulier des microcolonnes de chromatographie en phase gazeuse, des interconnexions diélectriques dans des systèmes micro et/ou nanoélectromécaniques.

## Revendications

1. Procédé de réalisation d'une couche mince de SiOCH poreux comportant les étapes :
- dépôt d'une couche mince de SiOCH (2) par dépôt chimique en phase vapeur à partir d'un seul précurseur choisi parmi le diméthylsilane, le triméthylsilane et le tétraméthylsilane à une température comprise entre 100°C et 250°C, un flux d'oxygène étant également injecté lors du dépôt,
- traitement thermique de ladite couche mince (2), directement après le dépôt de la couche mince (2), à une température comprise entre 350°C et 500°C.

2. Procédé de réalisation d'une couche mince de SiOCH poreux selon la revendication 1, dans lequel le dépôt est réalisé par dépôt chimique en phase vapeur assisté par plasma.

3. Procédé de réalisation d'une couche mince de SiOCH poreux selon la revendication 1 ou 2, dans lequel le traitement thermique est assisté par un rayonnement UV.

4. Procédé de réalisation d'une couche mince de SiOCH poreux selon l'une des revendications 1 à 3, dans lequel le traitement thermique est réalisé à 400°C.

5. Procédé de réalisation d'une couche mince de SiOCH poreux selon l'une des revendications 1 à 4, dans lequel la température de dépôt est égale à 150°C.

6. Utilisation d'un procédé de réalisation 'une couche de SiOCH poreux selon l'une des revendications 1 à 5 pour réaliser une colonne de chromatographie, ladite couche de SiOCH poreux étant formée sur une surface intérieure de la colonne.

7. Utilisation d'un procédé de réalisation d'une couche de SiOCH poreux selon l'une des revendications 1 à 5, pour former un capteur de gaz, ladite couche de SIOCH étant destinée à adsorber au moins une espèce d'intérêt.

## Patentansprüche

1. Verfahren zur Herstellung einer Dünnschicht aus porösem SiOCH, umfassend die Schritte:
- Abscheiden einer Dünnschicht aus SiOCH (2) durch chemische Dampfphasenabscheidung aus einem einzigen Vorläufer, ausgewählt aus Dimethylsilan, Trimethylsilan und Tetramethylsilan, bei einer Temperatur zwischen 100°C und 250°C, wobei während der Abscheidung auch ein Sauerstoffstrom eingeleitet wird,
- Wärmebehandlung der Dünnschicht (2) bei einer Temperatur zwischen 350°C und 500°C direkt nach dem Abscheiden der dünnen Schicht (2).

2. Verfahren zur Herstellung einer Dünnschicht aus porösem SiOCH nach Anspruch 1, wobei das Abscheiden durch plasmaunterstützte chemische Gasphasenabscheidung erfolgt.

3. Verfahren zur Herstellung einer Dünnschicht aus porösem SiOCH nach Anspruch 1 oder 2, wobei die Wärmebehandlung durch UV-Strahlung unterstützt wird.

4. Verfahren zur Herstellung einer Dünnschicht aus porösem SiOCH nach einem der Ansprüche 1 bis 3, wobei die Wärmebehandlung bei 400°C durchgeführt wird.

5. Verfahren zur Herstellung einer Dünnschicht aus porösem SiOCH nach einem der Ansprüche 1 bis 4, wobei die Abscheidungstemperatur gleich 150°C ist.

6. Anwendung eines Verfahrens zur Herstellung einer Schicht aus porösem SiOCH nach einem der Ansprüche 1 bis 5 zur Herstellung einer Chromatographiesäule, wobei die Schicht aus porösem SiOCH auf einer Innenfläche der Säule ausgebildet wird.

7. Anwendung eines Verfahrens zur Herstellung einer Schicht aus porösem SiOCH nach einem der Ansprüche 1 bis 5 zum Ausbilden eines Gassensors, wobei die SiOCH-Schicht dazu bestimmt ist, zumindest eine interessierende Spezies zu adsorbieren.

## Claims

1. A method for making a thin layer of porous SiOCH including the following steps of:
- depositing a thin layer of SiOCH (2) by chemical vapour deposition from a single precursor selected from dimethylsilane, trimethylsilane and tetramethylsilane at a temperature between 100°C and 250°C, an oxygen stream being also injected upon depositing,
- heat treating said thin layer (2), directly after depositing the thin layer (2), at a temperature between 350°C and 500°C.

2. The method for making a thin layer of porous SiOCH according to claim 1, wherein depositing is made by plasma-assisted chemical vapour deposition.

3. The method for making a thin layer of porous SiOCH according to claim 1 or 2, wherein heat treating is assisted by a UV radiation.

4. The method for making a thin layer of porous SiOCH according to one of claims 1 to 3, wherein heat treating is performed at 400°C.

5. The method for making a thin layer of porous SiOCH according to one of claims 1 to 4, wherein the deposition temperature is equal to 150°C.

6. A use of a method for making a layer of porous SiOCH according to one of claims 1 to 5, to make a chromatography column, said layer of porous SiOCH being formed on an internal surface of the column.

7. A use of a method for making a layer of porous SiOCH according to one of claims 1 to 5, to form a gas sensor, said layer of SiOCH being to adsorb at least one species of interest.
